(19) Europäisches Patentamt / European Patent Office / Office européen des brevets

(11) **EP 1 801 782 A1**

(12) **EUROPEAN PATENT APPLICATION**
published in accordance with Art. 158(3) EPC

(43) Date of publication:
**27.06.2007 Bulletin 2007/26**

(51) Int Cl.:
**G10L 19/00** *(2006.01)*

(21) Application number: **05786017.3**

(22) Date of filing: **26.09.2005**

(86) International application number:
**PCT/JP2005/017618**

(87) International publication number:
**WO 2006/035705 (06.04.2006 Gazette 2006/14)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **28.09.2004 JP 2004282525**

(71) Applicant: **Matsushita Electric Industrial Co., Ltd.**
**Kadoma-shi,**
**Osaka 571-8501 (JP)**

(72) Inventors:
• **GOTO, Michiyo**
**Matsushita Elect.Ind.Co.Ltd**
**Chuo-ku,Osaka-shi,Osaka 540-6319 (JP)**
• **YOSHIDA, Koji**
**Matsushita Elect.Ind.Co.Ltd**
**Chuo-ku,Osaka-shi,Osaka 540-6319 (JP)**

(74) Representative: **Grünecker, Kinkeldey,**
**Stockmair & Schwanhäusser**
**Anwaltssozietät**
**Maximilianstrasse 58**
**80538 München (DE)**

(54) **SCALABLE ENCODING APPARATUS AND SCALABLE ENCODING METHOD**

(57) A scalable encoding apparatus wherein stereo audio signals can be scalable encoded by use of a CELP encoding to improve the encoding efficiency. In the apparatus, an adder (101) and a multiplier (102) obtain an average of first and second channel signals (CH1,CH2) as a monophonic signal (M) . A CELP encoding part (103) performs a CELP encoding of the monophonic signal (M).

A first channel difference information encoding part (104) performs an encoding of the first channel signal (CH1) in conformance with the CELP encoding and obtains a difference between a resulting encoded parameter and an encoded parameter outputted from the CELP encoding part (103). The first channel difference information encoding part (104) then encodes this difference and outputs the resulting encoded parameter.

FIG.1

**Description**

Technical Field

The present invention relates to a scalable encoding apparatus and a scalable encoding method that perform scalable encoding of a stereo speech signal by a CELP method (hereinafter referred to simply as CELP encoding).

Background Art

In speech communication of a mobile communication system, communication using a monaural scheme (monaural communication) is a mainstream, such as communication using mobile telephones. However, if a transmission rate increases further as in the fourth-generation mobile communication system, it is possible to maintain an adequate bandwidth for transmitting a plurality of channels. It is therefore expected that communication using a stereo system (stereo communication) will be widely used in speech communication as well.

For example, considering the increasing number of users who enjoy stereo music by storing music in portable audio players that are equipped with a HDD (hard disk) and attaching stereo earphones, headphones, or the like to the player, it is anticipated that mobile telephones will be combined with music players in the future, and that a lifestyle of using stereo earphones, headphones, or other equipments and performing speech communication using a stereo system will become prevalent. In order to realize realistic conversation in the environment such as in currently popularized TV conference, it is anticipated that stereo communication is used.

Even when stereo communication becomes common, it is assumed that monaural communication will also be used. This is because monaural communication has a low bit rate, and a lower cost of communication can therefore be expected. Further, a mobile telephone which supports only monaural communication has a smaller circuit scale and is therefore inexpensive. Users who do not need high-quality speech communication will purchase mobile telephones which support only monaural communication. Accordingly, in a single communication system, mobile telephones which support stereo communication and mobile telephones which support monaural communication will coexist. Therefore, the communication system will have to support both stereo communication and monaural communication.

In the mobile communication system, communication data is exchanged using radio signals, a part of the communication data is sometimes lost according to the propagation path environment. Therefore, if the mobile telephone has a function of restoring the original communication data from the residual received data even in this case, it is extremely useful.

There is scalable encoding composed of a stereo signal and a monaural signal. This type of encoding can support both stereo communication and monaural communication and is capable of restoring the original communication data from residual received data even when a part of the communication data is lost. An example of a scalable encoding apparatus that has this function is disclosed in Non-patent Document 1, for example.

Non-patent Document 1: ISO/IEC 14496-3:1999 (B.14 Scalable AAC with core coder)

Disclosure of Invention

Problems to Be Solved by the Invention

However, the scalable encoding apparatus disclosed in Non-patent Document 1 is designed for an audio signal and does not assume a speech signal, and therefore there is a problem of decreasing encoding efficiency when the scalable encoding is applied to a speech signal as is. Specifically, for a speech signal, it is required to apply CELP encoding which is capable of efficient encoding, but Non-patent Document 1 does not disclose the specific configuration for the case where a CELP method is applied, particularly where CELP encoding is applied in an extension layer. Even when CELP encoding optimized for the speech signal which is not assumed to that apparatus is applied as is, the desired encoding efficiency is difficult to obtain.

It is therefore an object of the present invention to provide a scalable encoding apparatus and a scalable encoding method capable of realizing scalable encoding of a stereo speech signal using a CELP method and improving encoding efficiency.

Means for Solving the Problem

The scalable encoding apparatus of the present invention has: a generating section that generates a monaural speech signal from a stereo speech signal; a first encoder that encodes the monaural speech signal by a CELP method and obtains an encoded parameter of the monaural speech signal; and a second encoder that designates an R channel or an L channel of the stereo speech signal as a channel targeted for encoding, calculates a difference between the encoded parameter of the monaural speech signal and a parameter obtained by performing linear prediction analysis and an adaptive excitation codebook search for the channel targeted for encoding, and obtains an encoded parameter of the channel targeted for encoding from the difference.

Advantageous Effect of the Invention

According to the present invention, it is possible to perform scalable encoding of a stereo speech signal using CELP encoding and improve encoding efficiency.

Brief Description of Drawings

FIG.1 is a block diagram showing the main configuration of the scalable encoding apparatus according to embodiment 1;
FIG.2 shows the relationship of the monaural signal, the first channel signal and the second channel signal;
FIG.3 is a block diagram showing the main internal configuration of the CELP encoder according to embodiment 1;
FIG.4 is a block diagram showing the main internal configuration of the first channel difference information encoder according to embodiment 1;
FIG.5 is a block diagram showing the main configuration of the scalable encoding device according to embodiment 2; and
FIG.6 is a block diagram showing the main internal configuration of the second channel difference information encoder according to embodiment 2.

Best Mode for Carrying Out the Invention

Embodiments of the present invention will be described in detail hereinafter with reference to the accompanying drawings. The case will be described as an example where the stereo speech signal formed with two channels is encoded, wherein the first channel and the second channel described hereinafter are an L channel and an R channel, respectively, or an R channel and an L channel, respectively.

(Embodiment 1)

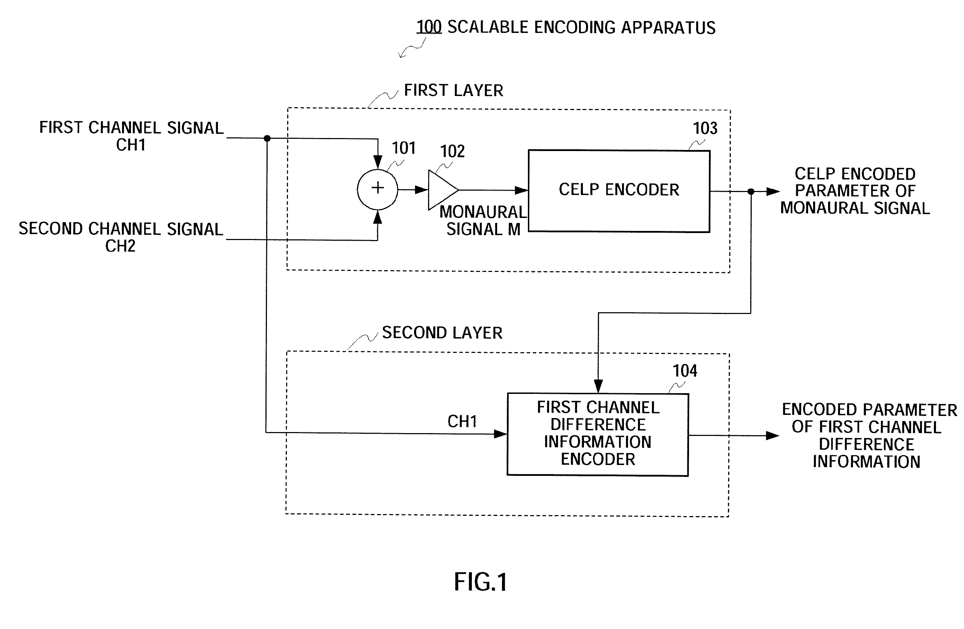

FIG.1 is a block diagram showing the main configuration of scalable encoding apparatus 100 according to embodiment 1 of the present invention. Scalable encoding apparatus 100 is provided with an adder 101, a multiplier 102, a CELP encoder 103, and a first channel difference information encoder 104.
Each section of scalable encoding apparatus 100 performs the operation described below.
Adder 101 adds first channel signal CH1 and second channel signal CH2 which are inputted to scalable encoding apparatus 100 to generate a sum signal. Multiplier 102 multiplies the sum signal by 1/2 to divide the scale in half and generates monaural signal M. Specifically, adder 101 and multiplier 102 calculate the average signal of first channel signal CH1 and second channel signal CH2 and set the average signal as monaural signal M.
CELP encoder 103 performs CELP encoding of monaural signal M and outputs a monaural signal CELP encoded parameter to first channel difference information encoder 104 and an external unit of scalable encoding apparatus 100. The term "CELP encoded parameter" used herein refers to an LSP parameter, an adaptive excitation codebook index, an adaptive excitation gain, a fixed excitation codebook index, and a fixed excitation gain.
First channel difference information encoder 104 performs CELP encoding for first channel signal CH1 inputted to scalable encoding apparatus 100, and specifically performs encoding by linear prediction analysis, searching of an adaptive excitation codebook, and searching of a fixed excitation codebook; and calculates the difference between the encoded parameter obtained by the process described above and a CELP encoded parameter that is outputted from CELP encoder 103. When this encoding is also referred to simply as CELP encoding, the above-described processing corresponds to obtaining a difference in the level (stage) of the CELP encoded parameter for monaural signal M and first channel signal CH1. First channel difference information encoder 104 also encodes difference information (first channel difference information) relating to the first channel, and outputs the obtained encoded parameter of the first channel difference information to an external unit of scalable encoding apparatus 100.
One characteristic of scalable encoding apparatus 100 is that adder 101, multiplier 102, and CELP encoder 103 form a first layer, and first channel difference information encoder 104 forms a second layer, wherein the encoded parameter of the monaural signal is outputted from the first layer, and an encoded parameter that enables a stereo signal to be obtained by decoding in conjunction with the encoded parameter of the first layer (monaural signal) is outputted from the second layer. Specifically, the scalable encoding apparatus according to this embodiment performs scalable encoding that is composed of a monaural signal and a stereo signal.

According to this configuration, the decoding device that acquires the encoded parameters composed of the abovementioned first layer and second layer may be a scalable decoding device that is adapted to both stereo communication and monaural communication, or a decoding device that is adapted only to monaural communication. Even when the decoding device is a scalable decoding device that is adapted to both stereo communication and monaural communication, deterioration of the environment of the propagation channel may make it impossible to acquire the encoded parameter of the second layer, and it may only be possible to acquire the encoded parameter of the first layer. However, even in this case, the scalable decoding device can decode a monaural signal, albeit at low quality. When the scalable decoding device is able to acquire the encoded parameters of the first layer and second layer, both parameters can be used to decode a high-quality stereo signal.

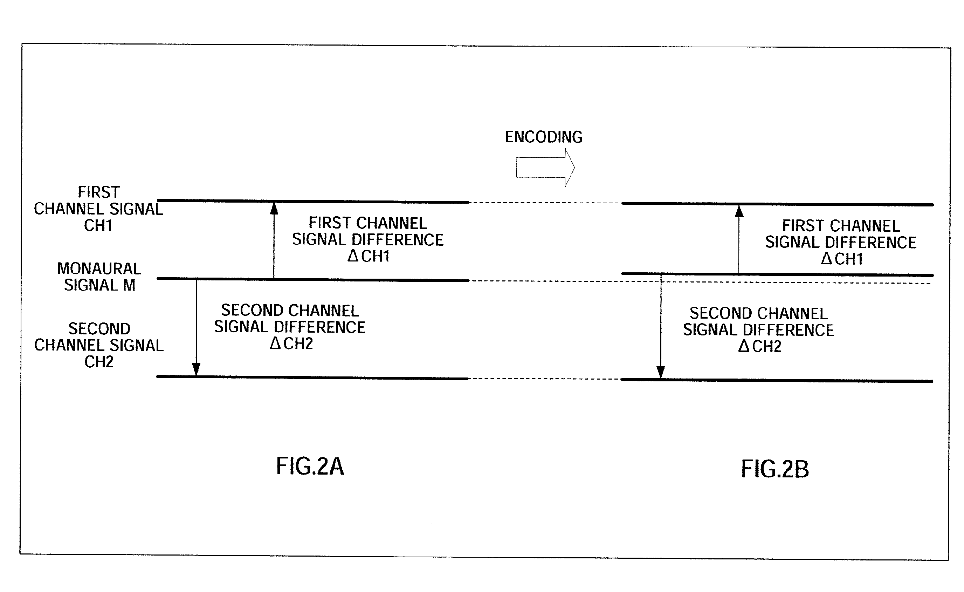

The principle by which the decoding apparatus can decode a stereo signal using the encoding parameters of the first layer and second layer outputted from scalable encoding apparatus 100 will be described hereinafter. FIG.2 is a diagram showing a comparison of the relationship between the monaural signal, the first channel signal, and the second channel signal before and after encoding.

Monaural signal M can be calculated by multiplying the sum of first channel signal CH1 and second channel signal CH2 by 1/2, i.e., by the following Equation (1).

$$M = (CH1 + CH2)/2 \quad (Equation \ 1)$$

Thus, when the difference (first channel signal difference) of CH1 with respect to monaural signal M is designated as $\Delta CH1$, CH1 satisfies the relationship of the following Equation (2) as shown in FIG.2A.

$$CH1 = M + \Delta CH1 \quad (Equation \ 2)$$

Accordingly, when CH1 is an encoded parameter, it is apparent that both encoded parameters of M and $\Delta CH1$ must be used to decode CH1.

In the same manner, the relationship shown in (3) below is established for the second channel signal CH2 when the difference (second channel signal difference) of CH2 with respect to monaural signal M is designated as $\Delta CH2$.

$$CH2 = M + \Delta CH2 \quad (Equation \ 3)$$

Therefore, when an approximation can be made as shown in Equation (4) below, Equation (3) can be written as Equation (5).

$$\Delta CH1 = -\Delta CH2 \quad (Equation \ 4)$$

$$CH2 = M - \Delta CH1 \quad (Equation \ 5)$$

Accordingly, when the approximation of Equation (4) above is established, it is apparent that the encoded parameter of CH2 can be indirectly decoded by decoding both encoded parameters of M and $\Delta CH1$, in the same manner as the encoded parameter of CH1.

However, encoding distortion usually occurs in the process of encoding. Strictly speaking, the sizes of $\Delta CH1$ and $\Delta CH2$ therefore vary after encoding, as shown in FIG.2B The meaning of Equation (4) above is therefore that the first channel difference information and the second channel difference information after encoding approach an equal size, i.e., it can be approximated that there is equality between the two encoding distortions that occur when the first channel and the second channel are encoded. Since these encoding distortions do not significantly vary in actual practice even in the actual device, it can be assumed that performing encoding while ignoring the difference between the encoding distortions of the first channel and the second channel does not lead to a significant degradation of the speech quality of the decoded signal.

Scalable encoding apparatus 100 according to the present embodiment therefore utilizes the principle described above to output the two encoded parameters of M and ΔCH1. The decoding device that acquires these parameters can decode not only CH1, but also CH2 by decoding M and ΔCH1.

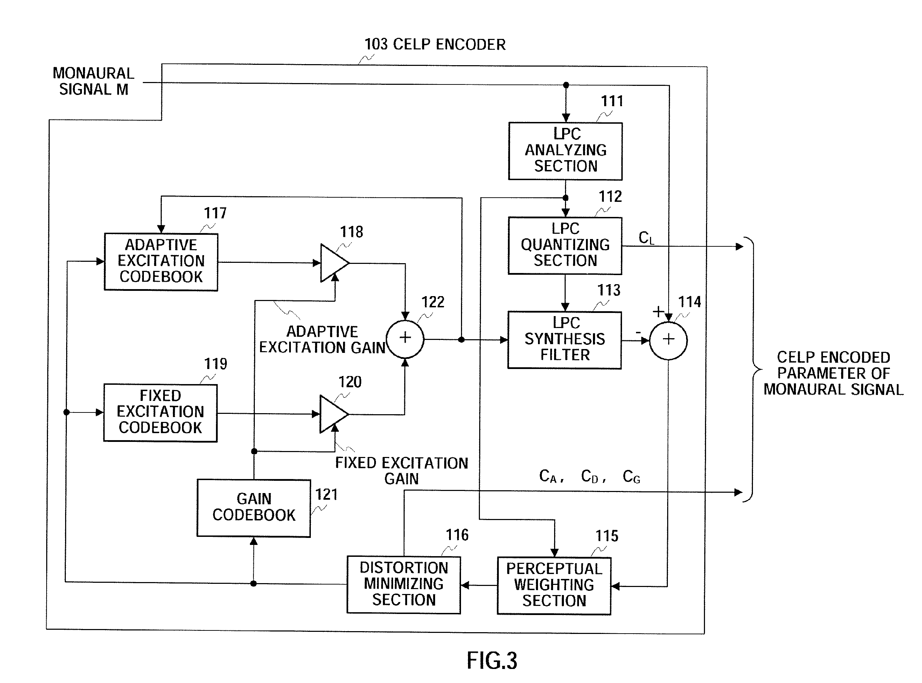

FIG.3 is a block diagram showing the main internal configuration of CELP encoder 103.

CELP encoder 103 is provided with an LPC analyzing section 111, an LPC quantizing section 112, an LPC synthesis filter 113, an adder 114, a perceptual weighting section 115, a distortion minimizing section 116, an adaptive excitation codebook 117, a multiplier 118, a fixed excitation codebook 119, a multiplier 120, a gain codebook 121, and an adder 122.

LPC analyzing section 111 performs linear prediction analysis on monaural signal M outputted from multiplier 102, and outputs the LPC parameter which is the analysis result to LPC quantizing section 112 and perceptual weighting section 115.

LPC quantizing section 112 quantizes the LSP parameter after converting the LPC parameter outputted from LPC analyzing section 111 to an LSP parameter that is suitable for quantization, and outputs the obtained quantized LSP parameter ($C_L$) to an external unit of CELP encoder 103. The quantized LSP parameter is one of the CELP encoded parameters obtained by CELP encoder 103. LPC quantizing section 112 reconverts the quantized LSP parameter to a quantized LPC parameter, and outputs the quantized LPC parameter to LPC synthesis filter 113.

LPC synthesis filter 113 uses the quantized LPC parameter outputted from LPC quantizing section 112 to perform synthesis by LPC synthesis filter using an excitation vector generated by adaptive excitation codebook 117 and fixed excitation codebook 119 (described hereinafter) as excitation. The synthesized signal thus obtained is outputted to adder 114.

Adder 114 inverts the polarity of the synthesized signal outputted from LPC synthesis filter 113, calculates an error signal by adding to monaural signal M, and outputs the error signal to perceptual weighting section 115. This error signal corresponds to the encoding distortion.

Perceptual weighting section 115 uses a perceptual weighting filter configured based on the LPC parameter outputted from LPC analyzing section 111 to perform perceptual weighting for the encoding distortion outputted from adder 114, and the signal is outputted to distortion minimizing section 116.

Distortion minimizing section 116 indicates various types of parameters to adaptive excitation codebook 117, fixed excitation codebook 119 and gain codebook 121 so as to minimize the encoding distortion that is outputted from perceptual weighting section 115. Specifically, distortion minimizing section 116 indicates indices ($C_A$, $C_D$, $C_G$) to adaptive excitation codebook 117, fixed excitation codebook 119 and gain codebook 121.

Adaptive excitation codebook 117 stores the previously generated excitation vector of the excitation for LPC synthesis filter 113 in an internal buffer, generates a single sub-frame portion from the stored excitation vector on the basis of an adaptive excitation lag that corresponds to the index that was specified from distortion minimizing section 116, and outputs the single sub-frame portion to multiplier 118 as an adaptive excitation vector.

Fixed excitation codebook 119 outputs the excitation vector, which corresponds to the index indicated from distortion minimizing section 116, to multiplier 120 as a fixed excitation vector.

Gain codebook 121 generates a gain that corresponds to the index indicated from distortion minimizing section 116, that is, a gain for the adaptive excitation vector from adaptive excitation codebook 117, and a gain for the fixed excitation vector from fixed excitation codebook 119, and outputs the gains to multipliers 118 and 120.

Multiplier 118 multiplies the adaptive excitation gain outputted from gain codebook 121 by the adaptive excitation vector outputted from adaptive excitation codebook 117, and outputs the result to adder 122.

Multiplier 120 multiplies the fixed excitation gain outputted from gain codebook 121 by the fixed excitation vector outputted from fixed excitation codebook 119, and outputs the result to adder 122.

Adder 122 adds the adaptive excitation vector outputted from multiplier 118 and the fixed excitation vector outputted from multiplier 120, and outputs the added excitation vector as excitation to LPC synthesis filter 113. Adder 122 also feeds back the obtained excitation vector of the excitation to adaptive excitation codebook 117.

As previously described, the excitation vector outputted from adder 122, that is, the excitation vector generated by adaptive excitation codebook 117 and fixed excitation codebook 119, is synthesized as excitation by LPC synthesis filter 113.

The sequence of routines whereby the encoding distortion is computed using the excitation vectors generated by adaptive excitation codebook 117 and fixed excitation codebook 119 is thus a closed loop (feedback loop), and distortion minimizing section 116 directs adaptive excitation codebook 117, fixed excitation codebook 119, and gain codebook 121 so as to minimize the encoding distortion. Distortion minimizing section 116 then outputs various types of CELP encoding parameters ($C_A$, $C_D$, $C_G$) that minimize the encoding distortion to an external unit of CELP encoder 103.

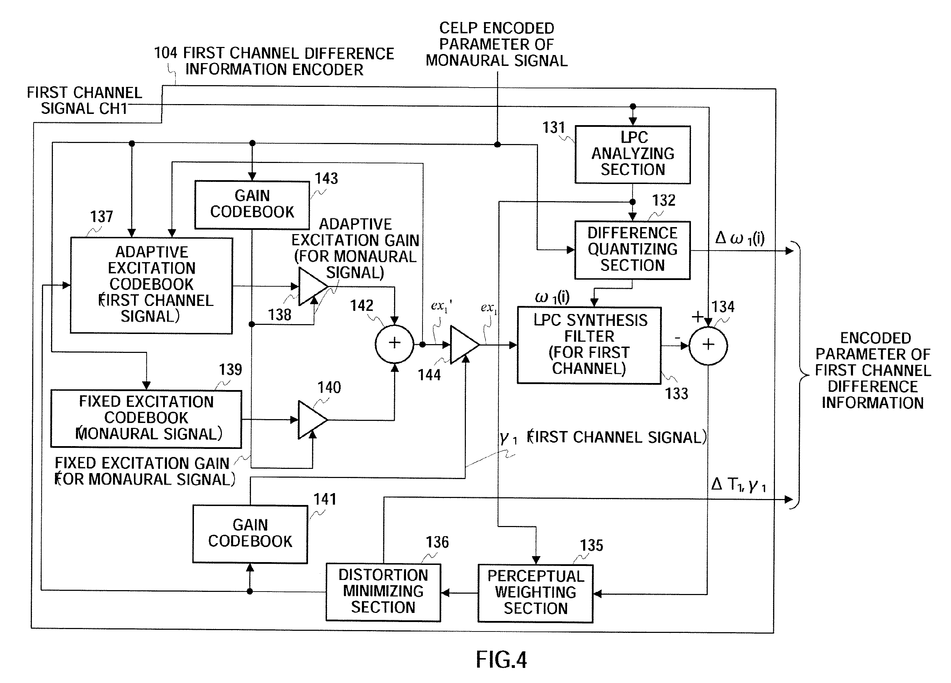

FIG.4 is a block diagram showing the main internal configuration of first channel difference information encoder 104.

First channel difference information encoder 104 encodes a spectral envelope component parameter and a excitation component parameter of first channel signal CH1 as a difference from monaural signal M. The term "excitation component parameter" used herein refers to an adaptive excitation codebook index, an adaptive excitation gain, a fixed excitation codebook index, and a fixed excitation gain.

In first channel difference information encoder 104, the same configuration is adopted for LPC analyzing section 131, LPC synthesis filter 133, adder 134, the perceptual weighting section 135, distortion minimizing section 136, multiplier 138, adder 140, and adder 142 as the one used for LPC analyzing section 111, LPC synthesis filter 113, adder 114, perceptual weighting section 115, distortion minimizing section 116, multiplier 118, multiplier 120, and adder 122, respectively, in CELP encoder 103. These components are therefore not described, and structural elements that differ from CELP encoder 103 are described in detail hereinafter.

A difference quantizing section 132 calculates the difference between the LPC parameter $\omega_1(i)$ of first channel signal CH1 obtained by LPC analyzing section 131, and the LPC parameter $(C_L)$ of monaural signal M already calculated by CELP encoder 103, quantizes this difference as the encoded parameter $\Delta\omega_1(i)$ of the spectral envelope component of the first channel difference information, and outputs the encoded parameter $\Delta\omega_1(i)$ to an external unit of first channel difference information encoder 104. Difference quantizing section 132 outputs the quantized parameter $\omega_1(i)$ of the LPC parameter of the first channel signal to LPC synthesis filter 133.

A gain codebook 143 uses the gain codebook index used for the monaural signal outputted from CELP encoder 103 as a basis for generating a corresponding adaptive excitation gain and fixed excitation gain, and outputs the adaptive excitation gain and fixed excitation gain to multipliers 138 and 140.

An adaptive excitation codebook 137 stores the excitation generated in a prior sub-frame in an internal buffer. In the case of voiced speech, since a prior excitation of the buffer of adaptive excitation codebook 137 has a strong correlation to the excitation waveform of the pitch waveform of the current frame, adaptive excitation codebook 137 extracts the excitation from the position of the pitch period past and periodically repeats the past excitation to generate a signal as a first approximation of. Adaptive excitation codebook 137 then encodes the pitch period, i.e., the adaptive excitation lag. In particular, adaptive excitation codebook 137 encodes the pitch period of CH1 by encoding the difference from the pitch period of monaural signal M already encoded by CELP encoder 103. The reason for this is that because monaural signal M is a signal that is generated from first channel signal CH1 and second channel signal CH2, monaural signal M is naturally considered to be highly similar to first channel signal CH1. In other words, the pitch period obtained with respect to monaural signal M is used as a reference to express the pitch period of first channel signal CH1 as a difference from the pitch period. This approach is believed to result in higher encoding efficiency than performing another search of the adaptive excitation codebook with respect to first channel signal CH1. Specifically, the pitch period $T_1$ of CH1 is indicated by the following Equation (6) . The Equation is obtained using the pitch period $T_M$ already computed for the monaural signal, and the difference parameter $\Delta T_1$ calculated from that value. Encoding is performed on $\Delta T_1$, which is the difference parameter for the case at which the optimum $T_1$ is obtained by searching the adaptive excitation codebook with respect to CH1.

[ 1 ]

$$T_1 = T_M + \Delta T_1 \qquad (\text{Equation 6})$$

A fixed excitation codebook 139 generates a excitation signal that represents a residual component in the excitation components of the current frame that cannot be approximated by the excitation signal generated by adaptive excitation codebook 137 on the basis of the past excitation. The residual component has a relatively small contribution to the synthesized signal in comparison to the component generated by adaptive excitation codebook 137. As previously mentioned, there is a high degree of similarity between monaural signal M and first channel signal CH1. The fixed excitation codebook index of CH1 that is used by fixed excitation codebook 139 is therefore the fixed excitation codebook index for monaural signal M used by fixed excitation codebook 119. This configuration corresponds to making the fixed excitation vector of CH1 the same signal as the fixed excitation vector of the monaural signal.

A gain codebook 141 specifies the gain of the adaptive excitation vector for CH1 by using two parameters that include the adaptive excitation gain for the monaural signal and a coefficient by which this adaptive excitation gain is multiplied. For the gain of the fixed excitation vector for CH1, gain codebook 141 similarly specifies the gain of the fixed excitation vector for CH1 by using two parameters that include the fixed excitation gain for the monaural signal and a coefficient by which this fixed excitation gain is multiplied. These two coefficients are determined as a shared gain multiplier $\gamma_1$ and outputted to a multiplier 144. The value of $\gamma_1$ is determined by a method in which the optimum gain index is selected from a gain codebook for CH1 that is prepared in advance, so as to minimize the difference between the synthesized signal of CH1 and the source signal of CH1.

Multiplier 144 multiplies γ1 by a excitation ex1' outputted from adder 142 to obtain ex1, and outputs the result to LPC synthesis filter 133.

According to the present embodiment thus configured, a monaural signal is generated from a first channel signal CH1 and a second channel signal CH2 that constitute a stereo signal, and the monaural signal is CELP encoded, wherein CH1 is encoded as a difference from the CELP parameter of the monaural signal. It is thereby possible to encode a stereo signal at a low bit rate with satisfactory quality.

In the method for encoding ΔCH1 in the configuration described above, a CELP encoded parameter of the monaural signal and a difference parameter with respect to the same are used to determine a difference parameter of CELP encoding so as to minimize the error between the source signal of CH1 and the synthesized signal of CH1 generated by the abovementioned parameters.

In the configuration described above, the difference in the stage of the CELP encoded parameter, rather than the waveform difference between the monaural signal and the first channel signal, was targeted for encoding in the second layer. The reason for this is considered to be that CELP encoding is primarily a technique for encoding by modeling human vocal cords/vocal tract, and when a difference is calculated based on waveform, the difference information thus obtained does not physically correspond to the CELP encoding model. Since it is considered to be impossible to perform efficient encoding by CELP encoding that involves using a waveform difference, the difference is obtained in the present invention in the stage of the CELP encoded parameter.

In the configuration described above, the difference ΔCH2 of CH2 with respect to the monaural signal is calculated using the abovementioned approximation Equation (4), and encoding is not performed. In the decoding device that receives the encoded parameter generated by the scalable encoding device of the present embodiment, the decoded signal can be obtained by calculation using the abovementioned Equation (5) from the received encoded parameter of ΔCH1.

An example was described in the present embodiment in which fixed excitation codebook 139 used the same index as fixed excitation codebook 119, i.e., a case in which fixed excitation codebook 139 generated the same fixed excitation vector as the fixed excitation vector for the monaural signal. However, the present invention is not limited to this configuration. For example, a configuration may be adopted in which a fixed excitation codebook search is performed for fixed excitation codebook 139, and a fixed excitation codebook index to be added for use with CH1 is determined in order to calculate an additive fixed excitation vector such as one added to the fixed excitation vector of the monaural signal. In this case, the encoding bit rate increases, but higher quality encoding of CH1 can be achieved.

An example was also described in the present embodiment of a case in which the adaptive excitation gain and the fixed excitation gain were multiplied by a common coefficient, such as γ₁ outputted from gain codebook 141. However, these two coefficients need not be the same. Specifically, encoding may be performed separately by using γ₁ as the coefficient by which the adaptive excitation gain is multiplied, and γ₂ as the coefficient by which the fixed excitation gain is multiplied. In this case, γ₁ may be determined in the same manner as when a common gain is used, and the determination is made by a method in which the optimum gain index is selected from a gain codebook for CH1 prepared in advance, so as to minimize the error between the synthesized signal of CH1 and the source signal of CH1. In this instance, γ₂ is determined by the same method as γ₁. In this method, the optimum gain index is selected from a gain codebook for CH2 prepared in advance, so as to minimize the error between the synthesized signal of CH1 and the source signal of CH2.

(Embodiment 2)

In embodiment 1, the encoding distortion of the first channel and the encoding distortion of the second channel were assumed to be approximately equal, and the scalable encoding device performed encoding using two layers that included a first layer and a second layer. In the configuration of the present embodiment, a third layer is newly provided to more accurately encode CH2, and in this third layer, the difference between the encoding distortion of the first channel and the second channel is encoded. More specifically, the difference between the encoding distortion included in the first channel difference information and the encoding distortion included in the second channel difference information is furthermore encoded, and the result is outputted as new encoded information.

Specifically, ΔCH2' described below is defined, and encoding is performed so as to reduce the quantization error (encoding distortion) included in ΔCH1. More specifically, encoding is performed on the difference signal ΔCH2' (= CH2 - M + ΔCH1) between CH2 signal and the prediction signal CH2' (= M - ΔCH1) of CH2 estimated from the monaural signal encoded in the first layer and ΔCH1 encoded in the second layer.

In the method for encoding ΔCH2', ΔCH2' is encoded using a CELP encoded parameter of CH2 estimated using two parameters that include a CELP encoded parameter of the monaural signal and a difference CELP parameter encoded in the second layer. The encoding is also performed using a correction parameter that corresponds to the CELP encoded parameter, and the correction parameter is determined so as to minimize the error between the synthesis signal of CH2, that are generated by the CELP encoded parameter of CH2 and the corresponding correction parameter, and the source signal of CH2. The reason that the waveform difference as such is not subjected to CELP encoding in the same manner as in the second layer is the same as in embodiment 1.

This configuration enables efficient stereo encoding that has good precision and is scalable between a monaural signal and a stereo signal. More efficient encoding is made possible by estimating the CELP encoded parameter of CH2 using the monaural parameter and the difference parameter between monaural and CH1, and encoding the corresponding error portion.

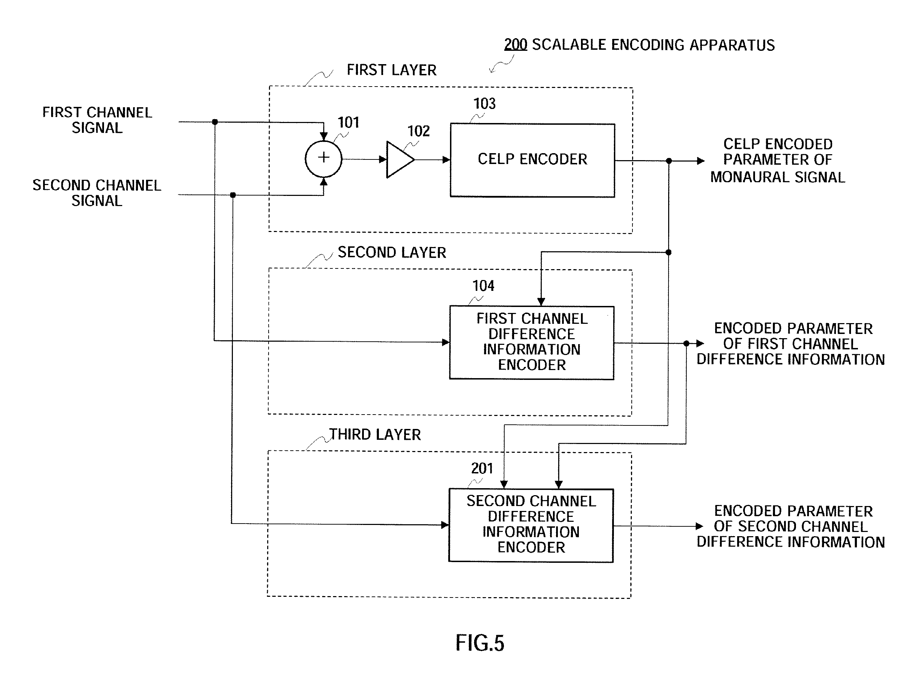

FIG.5 is a block diagram showing the main configuration of the scalable encoding apparatus 200 according to embodiment 2 of the present invention. Scalable encoding apparatus 200 has the same basic structure as scalable encoding apparatus 100 described in embodiment 1. Constituent elements thereof that are the same are indicated by the same reference symbols, and no description of these components will be given. A novel aspect of the configuration is a second channel difference information encoder 201 that forms a third layer.

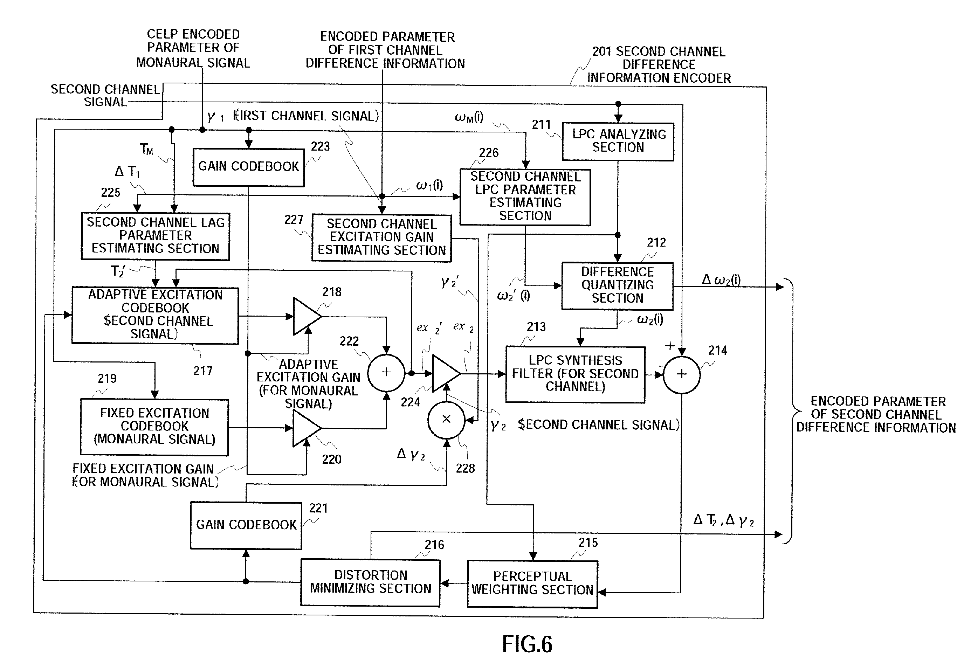

FIG.6 is a block diagram showing the main internal configuration of second channel difference information encoder 201.

In second channel difference information encoder 201, the same configuration is adopted for LPC analyzing section 211, difference quantizing section 212, LPC synthesis filter 213, adder 214, perceptual weighting section 215, the distortion minimizing section 216, adaptive excitation codebook 217, multiplier 218, fixed excitation codebook 219, multiplier 220, the gain codebook 221, adder 222, gain codebook 223, and multiplier 224 as the one used for LPC analyzing section 131, difference quantizing section 132, LPC synthesis filter 133, adder 134, perceptual weighting section 135, distortion minimizing section 136, adaptive excitation codebook 137, multiplier 138, fixed excitation codebook 139, adder 140, gain codebook 141, adder 142, gain codebook 143, and multiplier 144, respectively, in first channel difference information encoder 104 described above, and will therefore not be described.

A second channel lag parameter estimating section 225 uses the pitch period $T_M$ of the monaural signal and $\Delta T_1$, which is the CELP encoded parameter of CH1, to predict the pitch period (adaptive excitation lag) of CH2, and outputs the predicted value $T_2'$ to adaptive excitation codebook 217. The CELP encoded parameter $\Delta T_1$ of CH1 herein is calculated as the difference between the pitch period $T_M$ of the monaural signal and the pitch period $T_1$ of CH1.

A second channel LPC parameter estimating section 226 predicts the LPC parameter of CH2 by using the LPC parameter $\Delta M(i)$ of the monaural signal and the LPC parameter $\omega_1(i)$ of CH1, and outputs the predicted value $\omega_2'(i)$ to difference quantizing section 212.

Taking advantage of the fact that the excitation of the monaural signal is calculated from the excitation of CH1 and CH2 by using the abovementioned Equation (1), a second channel excitation gain estimating section 227 predicts the gain multiplier value of CH2 from the gain multiplier value $\gamma_1$ of CH1 by the inverse operation, and outputs the predicted value $\gamma_2'$ to a multiplier 228. The predicted value $\gamma_2'$ is multiplied by the second channel excitation gain $\Delta\gamma_2$ outputted from gain codebook 221.

The closed-loop encoding controlled by distortion minimizing section 216, i.e., the method for encoding the pitch period (adaptive excitation lag) $T_2$ of second channel signal CH2, comprises using the pitch period $T_M$ of the already encoded monaural signal and the difference $\Delta T_1$ between $T_M$ and the pitch period $T_1$ of CH1 to predict the pitch period $T_2$ of CH2 (predicted value $T_2'$), and encoding the difference (error component) from the predicted pitch period $T_2'$. First, Equation (7) below is assumed.

[ 2 ]

$$T_M \cong (T_1 + T_2)/2 \qquad (Equation\ 7)$$

Because of the relationship of Equation (8) below, the predicted value $T_2'$ of $T_2$ is indicated by Equation (9) from Equation (7) above.

[ 3 ]

$$T_1 = T_M + \Delta T_1 \qquad (Equation\ 8)$$

[ 4 ]

$$T_2' = 2T_M - T_1 \qquad (Equation\ 9)$$

When Equation (8) is substituted into Equation (9), Equation (10) below is obtained.

[ 5 ]

$$T_2' = T_M - \Delta T_1 \qquad (\text{Equation 10})$$

The pitch period $T_2$ of CH2 is thus indicated by Equation (11) below by the predicted value $T_2'$ thereof and the corresponding correction value $\Delta T_2$.

[ 6 ]

$$T_2 = T_2' + \Delta T_2 \qquad (\text{Equation 11})$$

When (10) is substituted into Equation (11), Equation (12) below is obtained.

[ 7 ]

$$T_2 = (T_M - \Delta T_1) + \Delta T_2 \qquad (\text{Equation 12})$$

The scalable encoding device of the present embodiment searches the adaptive excitation codebook for CH2 and encodes the correction parameter $\Delta T_2$ of the case at which the optimum $T_2$ is obtained. Here, $\Delta T_2$ is the error portion with respect to the predicted value that is estimated using the monaural parameter $T_M$ and the difference parameter $\Delta T_1$ with respect to monaural in CH1. This portion is therefore an extremely small value compared to $\Delta T1$, and more efficient encoding can be performed.

Similar to fixed excitation codebook 139 of first channel difference information encoder 104, fixed excitation codebook 219 generates a excitation signal for a residual component that cannot be approximated by the excitation signal generated by adaptive excitation codebook 217 from the excitation components of the current frame. Similar to fixed excitation codebook 139, fixed excitation codebook 219 uses the fixed excitation codebook index of monaural signal M as the fixed excitation codebook index of CH2. Specifically, the fixed excitation vecotr of CH2 is made into the same signal as the fixed excitation vector of the monaural signal.

Since an additive fixed excitation vector such as one added to the fixed excitation vector of the monaural signal is calculated in the same manner as in embodiment 1, a fixed excitation codebook search may be performed for fixed excitation codebook 219, and a fixed excitation codebook index that is added for use with CH2 may be calculated. In this case, the encoding bit rate increases, but higher quality encoding of CH2 can be achieved.

Gain codebook 221 specifies a excitation vector gain for CH2 as a gain multiplier $\gamma_2$ by which the adaptive excitation gain and the fixed excitation vector gain for the monaural signal are both multiplied. Specifically, the gain for the monaural signal is already calculated in CELP encoder 103, and the gain multiplier $\gamma_1$ for CH1 is already calculated in first channel difference information encoder 104. Therefore, gain codebook 221 specifies the multiplier $\gamma_2$ for CH2 by calculating the estimated value $\gamma_2'$ predicted from the gain for the monaural signal and the gain multiplier $\gamma_1$ and determining the correction value $\Delta\gamma_2$ with respect to the predicted estimated value $\gamma_2'$. The correction value $\Delta\gamma_2$ is determined by selecting a pattern that minimizes waveform distortion between the synthesized signal of CH2 and the input signal of CH2. The pattern is selected from among the patterns prepared in the gain codebook.

More specifically, gain codebook 221 estimates the gain multiplier $\gamma_2$ for CH2 from the gain multiplier $\gamma_1$ of CH1. Equation (13) below is obtained, wherein the excitation of the monaural signal is $ex_M(n)$, the excitation of CH1 is $ex_1(n)$, and the excitation of CH2 is $ex_2(n)$.

[ 8 ]

$$ex_M(n) = \frac{1}{2}(ex_1(n) + ex_2(n)) \qquad (\text{Equation 13})$$

Equation (13) above becomes Equation (16) when the predicted value of $\gamma_2$ is set as $\gamma_2$' and used in Equation (14) and Equation (15) below.

[9]

$$ex_1(n) = \gamma_1 \cdot ex_1'(n) \qquad \text{(Equation 14)}$$

$$ex_2(n) = \gamma_2' \cdot ex_2'(n) \qquad \text{(Equation 15)}$$

[10]

$$ex_M(n) = \frac{1}{2}(\gamma_1 \cdot ex_1'(n) + \gamma_2' \cdot ex_2'(n)) \qquad \text{(Equation 16)}$$

When the correlation between $ex_1'(n)$ and $ex_2'(n)$ here is assumed to be high, the relationships of Equation (17) and Equation (18) are satisfied.

[11]

$$\sum_n ex_1'(n) \cdot ex_2'(n) \cong \sum_n ex_M(n)^2 \qquad \text{(Equation 17)}$$

[12]

$$\sum_n ex_1'(n)^2 \cong \sum_n ex_2'(n)^2 \cong \sum_n ex_M(n)^2 \qquad \text{(Equation 18)}$$

Equation (19) below is obtained by taking a square and summation for both sides of (16).

[13]

$$\sum_n ex_M(n)^2 = \frac{1}{4}(\gamma_1^2 \sum_n ex_1'(n)^2 + \gamma_2'^2 \sum_n ex_2'(n)^2 + 2\gamma_1 \cdot \gamma_2' \sum_n ex_1'(n) \cdot ex_2'(n))$$

$$\text{(Equation 19)}$$

When Equation (15),Equation (17) and Equation (18) are substituted into Equation (19), Equation (20) below is obtained.

[14]

$$\sum_n ex_M(n)^2 = \frac{1}{4}\sum_n ex_M(n)^2 (\gamma_1^2 + \gamma_2'^2 + 2\gamma_1 \cdot \gamma_2') \qquad \text{(Equation 20)}$$

The relationship of Equation (21) below is obtained by solving Equation (20).

[15]

$$\gamma_2' = 2 - \gamma_1, \; -2 - \gamma_1 \quad (Equation \; 21)$$

Equation (22) below is obtained when $\gamma_2$ is the product of the predicted value $\gamma_2'$ and the corresponding correction coefficient $\Delta\gamma_2$ thereof.

[16]

$$\gamma_2 = \gamma_2' \cdot \Delta\gamma_2 \, (where, \; \gamma_2' = 2 - \gamma_1) \quad (Equation \; 22)$$

The correction coefficient $\Delta\gamma_2$ of the case at which the optimum $\gamma_2$ for CH2 is obtained is encoded by a gain codebook search. In the Equation, $\Delta\gamma_2$ is the correction portion with respect to the predicted value that was estimated using the monaural gain and the gain multiplier $\gamma_1$ for monaural in CH1. This portion is therefore an extremely small value compared to $\gamma_1$, and encoding can be performed more efficiently.

A spectral envelope component parameter of CH2 is obtained by calculating an LPC parameter by LPC analysis of the CH2 signal, estimating the LPC parameter of CH2 using the already calculated LPC parameter of the monaural signal and the difference component of the LPC parameter of CH1 with respect to the LPC parameter of the monaural signal, and quantizing the correction portion (error component) from the estimated parameter.

The LSP parameter $\omega_2$ (i) (wherein i = 0, 1, ..., p - 1) of CH2 is calculated from both the LSP parameter $\omega_M$(i) of the monaural signal and the difference $\Delta\omega_1$(i) between the LSP parameter $\omega_1$(i) of the first channel signal and the LSP parameter $\omega_M$(i) of the monaural signal.

Equation (23) below is first assumed.

[17]

$$\omega_M(i) \cong \frac{1}{2}(\omega_1(i) + \omega_2(i)) \quad (Equation \; 23)$$

The LSP parameter $\omega_1$(i) of CH1 is also indicated by Equation (24) below.

[18]

$$\omega_1(i) = \omega_M(i) + \Delta\omega_1(i) \quad (Equation \; 24)$$

The predicted value $\omega_2'$(i) of $\omega_2$(i) is thus indicated by Equation (25) below from Equation (23) and Equation (24).

[19]

$$\omega_2'(i) = \omega_M(i) - \Delta\omega_1(i) \quad (Equation \; 25)$$

The LSP $\omega_2$(i) of CH2 is indicated by Equation (26) below using the predicted value $\omega_2'$(i) thereof and the corresponding correction portion $\Delta\omega_2'$(i).

[20]

$$\omega_2(i) = \omega_2'(i) + \Delta\omega_2(i) \qquad (\text{Equation} \ 26)$$

When Equation (25) is substituted into Equation (26), Equation (27) below is obtained.

[21]

$$\omega_2(i) = \omega_M(i) - \Delta\omega_1(i) + \Delta\omega_2(i) \qquad (\text{Equation} \ 27)$$

The scalable encoding device of the present embodiment encodes the type of $\Delta\omega_2(i)$ that minimizes the quantization error with respect to $\omega2(i)$. Since $\Delta\omega_2(i)$ herein is an error portion with respect to a predicted value that is estimated using the monaural LSP parameter and the difference parameter $\Delta\omega1(i)$ for monaural in CH1, $\Delta\omega_2(i)$ is an extremely small value compared to $\Delta\omega_1(i)$, and encoding can be performed more efficiently.

In the present embodiment, ΔCH2' is thus encoded using the CELP encoded parameter of CH2 that is estimated using two parameters that include the CELP encoded parameter of the monaural signal and the difference CELP parameter encoded in the second layer. The encoding is also performed using the corresponding correction parameter. The abovementioned correction parameter is determined so as to minimize the error between the source signal of CH2 and the synthesis signal of CH2 generated by the CELP encoded parameter of CH2 and the corresponding correction parameter thereof. It is thereby possible to more accurately encode and decode CH2.

Embodiments 1 and 2 according to the present invention were described above.

In the embodiments described above, monaural signal M was the average signal of CH1 and CH2, but this is by no means limiting.

The adaptive excitation codebook is also sometimes referred to as an adaptive codebook. The fixed excitation codebook is also sometimes referred to as a fixed codebook, a noise codebook, a stochastic codebook or a random codebook.

The scalable encoding device of the present invention is not limited by the embodiments described above, and may include various types of modifications.

The scalable encoding device of the present invention can also be mounted in a communication terminal device and a base station device in a mobile communication system, thereby providing a communication terminal device and a base station device that have the same operational effects as those described above.

The case has been described as an example where the present invention is implemented with hardware, the present invention can be implemented with software.

Furthermore, each function block used to explain the above-described embodiments is typically implemented as an LSI constituted by an integrated circuit. These may be individual chips or may partially or totally contained on a single chip.

Here, each function block is described as an LSI, but this may also be referred to as IC, system LSI, super LSI, ultra LSI depending on differing extents of integration.

Further, the method of circuit integration is not limited to LSI's, and implementation using dedicated circuitry or general purpose processors is also possible. After LSI manufacture, utilization of a programmable FPGA (Field Programmable Gate Array) or a reconfigurable processor in which connections and settings of circuit cells within an LSI can be reconfigured is also possible.

Further, if integrated circuit technology comes out to replace LSI's as a result of the development of semiconductor technology or a derivative other technology, it is naturally also possible to carry out function block integration using this technology. Application in biotechnology is also possible.

This application is based on Japanese Patent Application No.2004-282525 filed on September 28, 2004, entire content of which is expressly incorporated herein by reference.

Industrial Applicability

The scalable encoding device and scalable encoding method of the present invention can be applied in a communication terminal device, a base station device, or other device that performs scalable encoding of a stereo signal in a mobile communication system.

**Claims**

1. A scalable encoding apparatus comprising:

   a generating section that generates a monaural speech signal from a stereo speech signal;
   a first encoding section that encodes the monaural speech signal by a CELP method and obtains an encoded parameter of the monaural speech signal; and
   a second encoding section that designates an R channel or an L channel of the stereo speech signal as a channel targeted for encoding, calculates a difference between the encoded parameter of the monaural speech signal and a parameter obtained by performing linear prediction analysis and an adaptive excitation codebook search for the channel targeted for encoding, and obtains an encoded parameter of the channel targeted for encoding from the difference.

2. The scalable encoding apparatus according to claim 1, wherein the generating section calculates an average of the R channel and the L channel and uses the average as the monaural speech signal.

3. The scalable encoding apparatus according to claim 1, wherein the second encoding section uses a fixed excitation codebook index of the encoded parameter of the monaural speech signal as a fixed excitation codebook index of the channel targeted for encoding.

4. The scalable encoding apparatus according to claim 1, wherein encoding is not performed for a channel other than the channel selected from the R channel and the L channel and targeted for encoding by the second encoding section.

5. The scalable encoding apparatus according to claim 1, further comprising:

   a third encoding section that designates as a channel targeted for encoding a channel other than the channel selected from the R channel and the L channel and targeted for encoding by the second encoding section, generates a synthesized signal using an encoded parameter obtained by the first and second encoding sections, and performs encoding so as to minimize encoding distortion of the synthesized signal.

6. A communication terminal apparatus comprising the scalable encoding apparatus according to claim 1.

7. A base station apparatus comprising the scalable encoding apparatus according to claim 1.

8. A scalable encoding method comprising:

   a generating step of generating a monaural speech signal from a stereo speech signal;
   a first encoding step of encoding the monaural speech signal by a CELP method and obtaining an encoded parameter of the monaural speech signal; and
   a second encoding step of designating an R channel or an L channel of the stereo speech signal as a channel targeted for encoding, calculating a difference between the encoded parameter of the monaural speech signal and a parameter obtained by performing linear prediction analysis and an adaptive excitation codebook search for the channel targeted for encoding, and obtaining an encoded parameter of the channel targeted for encoding from the difference.

100 SCALABLE ENCODING APPARATUS

FIRST LAYER

FIRST CHANNEL SIGNAL CH1

SECOND CHANNEL SIGNAL CH2

101

102

MONAURAL SIGNAL M

103 CELP ENCODER

CELP ENCODED PARAMETER OF MONAURAL SIGNAL

SECOND LAYER

CH1

104 FIRST CHANNEL DIFFERENCE INFORMATION ENCODER

ENCODED PARAMETER OF FIRST CHANNEL DIFFERENCE INFORMATION

FIG.1

EP 1 801 782 A1

FIRST CHANNEL SIGNAL CH1

MONAURAL SIGNAL M

SECOND CHANNEL SIGNAL CH2

FIRST CHANNEL SIGNAL DIFFERENCE ΔCH1

SECOND CHANNEL SIGNAL DIFFERENCE ΔCH2

ENCODING

FIG.2A

FIRST CHANNEL SIGNAL DIFFERENCE ΔCH1

SECOND CHANNEL SIGNAL DIFFERENCE ΔCH2

FIG.2B

15

FIG.3

103 CELP ENCODER

MONAURAL SIGNAL M

CELP ENCODED PARAMETER OF MONAURAL SIGNAL

111 LPC ANALYZING SECTION

112 LPC QUANTIZING SECTION

113 LPC SYNTHESIS FILTER

114

$C_L$

115 PERCEPTUAL WEIGHTING SECTION

116 DISTORTION MINIMIZING SECTION

$C_A$, $C_D$, $C_G$

117 ADAPTIVE EXCITATION CODEBOOK

118 ADAPTIVE EXCITATION GAIN

119 FIXED EXCITATION CODEBOOK

120 FIXED EXCITATION GAIN

121 GAIN CODEBOOK

122

FIG.4

FIG.5

EP 1 801 782 A1

FIG.6

**INTERNATIONAL SEARCH REPORT**

International application No.

PCT/JP2005/017618

A.  CLASSIFICATION OF SUBJECT MATTER
*G10L19/00* (2006.01)

According to International Patent Classification (IPC) or to both national classification and IPC

B.  FIELDS SEARCHED

Minimum documentation searched (classification system followed by classification symbols)
*G10L19/00* (2006.01)

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)
JSTPlus(JOIS)

C.  DOCUMENTS CONSIDERED TO BE RELEVANT

| Category* | Citation of document, with indication, where appropriate, of the relevant passages | Relevant to claim No. |
|---|---|---|
| A | JP 11-32399 A  (Sony Corp.),<br>02 February, 1999 (02.02.99),<br>Par. Nos. [0102] to [0125]<br>& US 6356211 B1        & EP 0878798 A2<br>& CN 1199202 A | 1-8 |
| A | JP 2003-58195 A  (Canon Inc.),<br>28 February, 2003 (28.02.03),<br>Par. No. [0004]<br>(Family: none) | 1-8 |
| A | JP 2004-509367 A  (Telefon AB. LM Ericsson),<br>25 March, 2004 (25.03.04),<br>Full text<br>& US 2003/0191635 A1      & EP 1325495 A1<br>& WO 2002/023529 A1      & SE 0003287 A<br>& AU 8635001 A | 3 |

☐  Further documents are listed in the continuation of Box C.          ☐  See patent family annex.

| | |
|---|---|
| *     Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| | |
|---|---|
| Date of the actual completion of the international search<br>07 November, 2005 (07.11.05) | Date of mailing of the international search report<br>15 November, 2005 (15.11.05) |
| Name and mailing address of the ISA/<br>Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004282525 A